# EUROPÄISCHE PATENTSCHRIFT

(11) **EP 3 022 330 B1**
(45) Veröffentlichungstag und Bekanntmachung des Hinweises auf die Patenterteilung: **13.06.2018**
(21) Anmeldenummer: 14739826.7
(22) Anmeldetag: 16.07.2014
(51) Int. Cl.: C23C 18/12, C09D 5/02, C09D 5/08, C09D 101/02, C09D 103/02, C09D 103/12, C09D 105/00, C09D 105/02, C09D 105/04, C09D 105/06, C09D 105/08, C09D 105/12, C09D 133/04, C09D 189/00, C09D 189/06, C09D 197/00, C23C 16/56

(54) **VERFAHREN ZUM BESCHICHTEN VON METALLISCHEN OBERFLÄCHEN VON SUBSTRATEN UND NACH DIESEM VERFAHREN BESCHICHTETEN GEGENSTÄNDE**
METHOD FOR COATING METAL SURFACES OF SUBSTRATES, AND OBJECTS COATED ACCORDING TO SAID METHOD
PROCÉDÉ DE REVÊTEMENT DE SURFACES MÉTALLIQUES DE SUBSTRATS ET OBJETS REVÊTUS PAR CE PROCÉDÉ

(30) Priorität: 18.07.2013 DE 102013214084
(43) Veröffentlichungstag der Anmeldung: 25.05.2016
(73) Patentinhaber: Chemetall GmbH, 60487 Frankfurt (DE)
(72) Erfinder: WASSERFALLEN, Daniel, 55128 Mainz (DE); SCHWAMB, Michael, 60325 Frankfurt (DE); FRENKEL, Aliaksandr, 60385 Frankfurt (DE); SOTKE, Vera, 60316 Frankfurt am Main (DE); BREMSER, Wolfgang, 33100 Paderborn (DE); DROLL, Martin, 33189 Schlangen (DE); SEEWALD, Oliver, 34431 Marsberg (DE); EILINGHOFF, Ron, 60487 Frankfurt (DE); GEROLD, Stephanie, 33102 Paderborn (DE); NIESEN, Evgenija, 59494 Soest (DE); SCHACHTSIEK, Lars, 33102 Paderborn (DE); TRAUT, Manuel, 59069 Hamm (DE); KLÖPZIG, Philipp, 64297 Darmstadt (DE)
(74) Vertreter: BASF IP Association
(86) Internationale Anmeldenummer: PCT/EP2014/065281
(87) Internationale Veröffentlichungsnummer: WO 2015/007789

(56) Entgegenhaltungen:
- DE-A1-102008 043 682
- DE-A1-102011 053 509
- US-A- 5 433 976
- US-A1- 2001 050 231
- MONTEMOR M F ET AL: "Modification of bis-silane solutions with rare-earth cations for improved corrosion protection of galvanized steel substrates", PROGRESS IN ORGANIC COATINGS, ELSEVIER BV, NL, Bd. 57, Nr. 1, 1. September 2006 (2006-09-01), Seiten 67-77, XP027906360, ISSN: 0300-9440 [gefunden am 2006-09-01]
- TRABELSI W ET AL: "The use of pre-treatments based on doped silane solutions for improved corrosion resistance of galvanised steel substrates", SURFACE AND COATINGS TECHNOLOGY, ELSEVIER, AMSTERDAM, NL, Bd. 200, Nr. 14-15, 10. April 2006 (2006-04-10), Seiten 4240-4250, XP024995592, ISSN: 0257-8972, DOI: 10.1016/J.SURFCOAT.2005.01.044 [gefunden am 2006-04-10]

## Beschreibung

Die Erfindung betrifft ein Verfahren zur Beschichtung von Oberflächen, eine entsprechende Beschichtung sowie die Verwendung der nach diesem Verfahren beschichteten Gegenstände. Es existieren zahlreiche Methoden, um auf insbesondere metallischen Oberflächen mittels Tauchverfahren homogene Beschichtungen zu erzeugen. Hierbei benutzt man für die Erzeugung von insbesondere Korrosionschutzbeschichtungen vorwiegend bestehend aus einer organischen Matrix oder/und organischen oder/und anorganischen Zusatzkomponenten vorzugsweise folgende Techniken.

Die klassischen Verfahren beruhen auf der Nutzung der rheologischen Eigenschaften der verwendeten Formulierungen, um eine vollständige Beschichtung eines gefügten Werkstückes zu erzielen. Obwohl durch kontinuierliches Rotieren des betreffenden Werkstückes nach dem Tauchvorgang eine Ansammlung von Beschichtungsmaterial an kritischen Stellen reduziert werden kann, ist es mit dieser Methode nicht möglich eine vollständig homogene Beschichtung zu erzielen. Zusätzlich können bei Stellen mit höheren Beschichtungsanteilen während des Trocknungs- oder/und Vernetzungsvorgangs Fehlstellen wie Blasenbildung und Kocher entstehen, die die Qualität der gesamten Beschichtung beeinträchtigen.

Die elektrophoretischen Verfahren vermeiden diese Problematik, indem elektrischer Strom eingesetzt wird, um eine gleichmäßige Beschichtung im Tauchen abzuscheiden. Mit dieser Methode gelingt die Erzeugung von homogenen Beschichtungen auf metallischen Werkstücken. Die abgeschiedenen Beschichtungen zeigen eine ausgesprochen gute Haftung im nassen Zustand zum metallischen Untergrund, was erlaubt ohne Ablösung der Beschichtung das Werkstück in einem nachfolgenden Spülschritt zu behandeln. Dies führt dazu, dass die vorab genannten schwer zugänglichen Stellen am Werkstück von überstehender Lackierlösung befreit werden und somit keine Fehlstellen während des Trocknungsvorgangs entstehen können. Diese Technik hat den Nachteil, dass neben der notwendigen Menge an elektrischer Energie und neben geeigneten Tauchbecken, die zu einer Erhöhung der Kosten führen, auch sogenannte Kantenfluchten auftreten, da elektrische Felder an makroskopischen Kanten inhomogen aufgebaut werden und die Kanten ungleichmäßig und eventuell auch unvollständig beschichtet werden. Bei dem Aufbau der Werkstücke müssen zudem Hohlräume vermieden werden, da an diesen Stellen ein Effekt vergleichbar mit dem Phänomen des Faraday'schen Käfigs auftritt. Aufgrund der Reduktion der zum Abscheiden notwendigen elektrischen Feldstärken kann an solchen Bereichen am Werkstück keine oder nur eine stark verringerte Beschichtung durch das Verfahren aufgebracht werden (Umgriffsproblematik), was zu einer Beeinträchtigung der Beschichtungsqualität führt. Zusätzlich weist diese Technik bei einer elektrischen Tauchlackierung (ETL) wie z.B. bei der kathodischen Tauchlackierung (KTL) die folgenden Nachteile auf: Ein entsprechendes Tauchbad ist zusammen mit allen elektrischen und mechanischen Einrichtungen von der Temperaturführung, Stromversorgung und elektrischen Isolierung, Umwälzeinrichtung und Zugabeeinrichtung bis zur Entsorgung der Anolyt-Säure, die bei der elektrolytischen Beschichtung entsteht, und mit einer Ultrafiltration zur Lackrezyklierung sowie Steuereinrichtungen sehr aufwendig aufgebaut. Die Prozessführung erfordert einen sehr hohen technischen Aufwand auch aufgrund der großen Stromstärken und Energiemengen sowie bei der Vergleichmäßigung der elektrischen Parameter über das Badvolumen und bei der präzisen Einstellung aller Prozessparameter sowie bei der Wartung und Säuberung der Anlage.

Die bekannten autophoretischen Verfahren beruhen auf einem stromlosen Konzept bestehend aus einem Beizangriff der eingesetzten Substratoberfläche, bei der Metallionen aus der Oberfläche herausgelöst werden und aufgrund der Konzentration an metallischen Ionen an der entstehenden Grenzfläche eine Emulsion koaguliert. Obwohl diese Verfahren nicht oben genannter Einschränkung der elektrolytischen Verfahren bezüglich dem Faraday'schen Käfigeffektes aufweisen, müssen die bei dem Prozess entstandenen Beschichtungen nach dem ersten Aktivierungsschritt in einem aufwendigen mehrstufigen Tauchverfahren fixiert werden. Desweiteren führt der Beizangriff zu einer unvermeidbaren Verunreinigung der aktiven Zone durch Metallionen, die aus den Zonen entfernt werden müssen. Zudem beruht die Methode auf einem chemischen Abscheidungsprozess, der nicht selbstregulierend ist und bei Bedarf nicht abgebrochen werden kann, wie z. B. durch das Ausschalten des elektrischen Stromes bei den elektrolytischen Verfahren. Somit ist bei einer längeren Verweildauer der metallischen Substrate in den aktiven Zonen die Ausbildung einer zu hohen Schichtstärke unvermeidbar.

Es ist ein lange verfolgter Wunsch, homogene Beschichtungen in einem Tauchprozess effizient und kostengünstig auszubilden, um hieraus möglichst geschlossene und im Wesentlichen ebene Beschichtungen in größerer Dicke herzustellen.

Die Erfindung betrifft ein Verfahren zum Beschichten von Oberflächen von Substraten umfassend die Schritte oder bestehend aus den Schritten:
I. Bereitstellen eines Substrats mit einer gereinigten Oberfläche,
II. Beschichten mit einer wässerigen Zusammensetzung in Form reiner Dispersion oder/und Suspension aus filmbildenden Polymeren, die aus einem Gemisch mindestens einer stabilisierten Polymer-Dispersion mit einem Feststoffgehalt von 30 bis 80 Gew.-% mit einem Gelbildner in einer Menge von 0,001 bis 20,0 Gew.-% bezogen auf die gesamte Masse des resultierenden Gemisches besteht sowie mit Kationen eine Beschichtung auf Basis eines ionogenen Gels ausbildet,
III. gegebenenfalls Spülen der organischen Beschichtung und
IV. Trocknen oder/und Einbrennen der organischen Beschichtung oder
V. gegebenenfalls Trocknen der organischen Beschichtung und Beschichten mit einer gleichartigen oder weiteren Beschichtungszusammensetzung vor einem Trocknen oder/und Einbrennen, wobei zwischen Schritt I und dem Schritt II eine zusätzliche Beschichtung mit einer wässerigen Zusammensetzung in Form einer Dispersion oder/und Suspension auf der Grundlage eines mehrwertige Metallkationen einlagendernden, kolloidalen silikatischen Sols und gegebenenfalls ein Spülvorgang erfolgt, wobei die mehrwertigen Kationen beim Ansetzen der wässerigen Zusammensetzung aus vollentsalztem Wasser zugesetzt werden, bevor die übrigen Bestandteile 2,9 g/L Gardobond® Additive H7107 und 22 g/L Gardobond® Oxsilan® Additive 9906 der Firma Chemetall eingestellt auf etwa pH 4,5 mit Gardobond® Oxsilan® Additive 9951 und 125 g/L Snowtex® O der Firma Nissan Chemical zugesetzt werden.

Die erfindungsgemäße Beschichtung zeigt einen einschichtigen Aufbau, wobei entweder eine mehr oder weniger homogene Beschichtung oder eine Beschichtung ausgebildet wird bzw. vorliegen kann, bei der die Partikel sich nahe der Oberfläche etwas stärker anreichern.

Unter den zu beschichtenden Substrate werden erfindungsgemäß verstanden: Metalle, metallisch beschichtete Oberflächen oder mit Primern vorbehandelte Metalloberflächen, aus denen Metallkationen noch herausgelöst werden können. Insbesondere umfasst der Begriff "zu beschichtende Oberfläche(n)" im Sinne dieser Anmeldung Oberflächen von metallischen Gegenständen oder/und metallischen Partikeln, die gegebenenfalls z.B. mit einer metallischen Beschichtung wie z.B. auf Basis von Zink oder Zinklegierung oder/und mit mindestens einer Beschichtung einer Vorbehandlungs- oder Behandlungszusammensetzung wie z.B. auf Basis von Chromat, Cr³⁺, Ti-Verbindung, Zr-Verbindung, Silan/Silanol/Siloxan/Polysiloxan oder/und organisches Polymer vorbeschichtet sein können. Als Substrate kommen alle Oberflächen in Frage, die sich mit einem mehrwertige Metallkationen einlagendernden, kolloidalen silikatischen Sol festhaftend beschichten lassen. Unter festhaftend wird in Sinne der vorliegenden Erfindung ein naß- oder luftgetrockneter Film verstanden, der sich durch Spülen im Tauch- und/oder Spritzverfahren mit vollentsalztem Wasser nicht entfernen läßt.

Unter den metallischen Werkstoffen sind grundsätzlich alle Arten von metallischen Werkstoffen möglich, insbesondere solche aus Aluminium, Eisen, Kupfer, Titan, Zink, Zinn oder/und Legierungen mit einem Gehalt an Aluminium, Eisen, Stahl, Kupfer, Magnesium, Nickel, Titan, Zink oder/und Zinn, wobei deren Einsatz auch benachbart oder/und nacheinander erfolgen kann. Die Werkstoffoberflächen können gegebenenfalls auch vorbeschichtet werden oder/und sein, beispielsweise mit Zink oder einer Aluminium oder/und Zink enthaltenden Legierung.

Als zu beschichtende Gegenstände können grundsätzlich alle Arten von Gegenständen eingesetzt werden, die aus einem metallischen Werkstoff bestehen oder mit mindestens einer metallischen Beschichtung versehen sind. Besonders bevorzugte Gegenstände sind insbesondere Bänder (Coils), Bleche, Teile wie z.B. Kleinteile, gefügte Komponenten, kompliziert geformte Komponenten, Profile, Stäbe oder/und Drähte.

Der Begriff "stromloses Beschichten" im Sinne dieser Anmeldung bedeutet, dass beim Beschichten mit der Lösung oder/und Dispersion (= Suspension oder/und Emulsion) enthaltenden Zusammensetzung im Gegensatz zu den bekannten elektrolytischen Verfahren zur Herstellung der Folgebeschichtung von außen eine elektrische Spannung kleiner 100 V angelegt wird.

Vorzugsweise betrifft die Erfindung ein Verfahren, bei dem der Gelbildner **a)** mindestens ein Polysacchariden auf Basis von Glykogenen, Amylosen, Amylopektinen, Callosen, Agar, Alginen, Alginaten, Pektinen, Carrageenen, Cellulosen, Chitinen, Chitosanen, Curdlanen, Dextranen, Fruktanen, Kollagenen, Gellan Gum, Gummi Arabicum, Stärken, Xanthanen, Traganth, Karayanen, Tarakernmehlen und Glucomannanen; **b)** mindestens ein Gelbildner natürlichen Ursprungs auf Basis von Polyaminosäuren, Kollagenen, Polypeptiden, Ligninen und/oder **c)** mindestens ein synthetischer Gelbildner auf Basis von Polyaminosäuren, Polyacrylsäuren, Polyacrylsäuren-Copolymere, Acrylamid-Copolymere, Ligninen, Polyvinylsulfonsäure, Polycarbonsäuren, Polyphosphorsäuren oder Polystyrolen enthält oder daraus besteht.

Besonders bevorzugt enthält oder besteht der Gelbildner aus mindestens ein Polysaccharid auf Basis von Pektinen und/oder Gellan Gum.

Vorzugsweise ist das erfindungsgemäße Verfahren eines, bei dem die wässerige Zusammensetzung oder/und die hieraus hergestellte organische Beschichtung mindestens eine Art von Kationen enthält, ausgewählt aus solchen auf Basis von kationisch wirkenden Salzen ausgewählt aus der Gruppe bestehend aus Melaminsalzen, Nitrososalzen, Oxoniumsalzen, Ammoniumsalzen, Salzen mit quaternären Stickstoffkationen, Salzen von Ammoniumderivaten und Metallsalzen von Ag, Al, Ba, Ca, Co, Cu, Fe, In, Mg, Mn, Mo, Ni, Pb, Sn, Ta, Ti, V, W, Zn oder/und Zr.

(Der Begriff "Copolymere" im Sinne dieser Anmeldung beschreibt Polymere, die aus zwei oder mehr verschiedenartigen Monomereinheiten zusammengesetzt sind. Hierbei können Copolymere in fünf Klassen unterteilt werden, wie anhand eines binären Copolymers, das aus zwei verschiedenen Comonomeren A und B aufgebaut ist, veranschaulicht wird:
1. Statistische Copolymere, in denen die Verteilung der beiden Monomeren in der Kette zufällig ist (AABABBBABAABBBABBABAB....);
2. Gradient-Copolymere, prinzipiell den statistischen Copolymeren ähnlich, jedoch mit veränderlichem Anteil eines Monomers im Verlauf der Kette (AAAAAABAABBAABABBBAABBBBBB);
3. Alternierende oder abwechselnde Copolymere mit einer regelmäßigen Anordnung der Monomeren entlang der Kette (ABABABABABABABABABAB....);
4. Blockcopolymere, die aus längeren Sequenzen oder Blöcken jedes Monomers besteht (AAAAAAAAABBBBBBBBBBBB...), wobei je nach Anzahl der Blöcke man auch von Diblock-, Triblock-, Multiblock-Copolymeren spricht;
5. Pfropfcopolymere, bei denen Blöcke eines Monomers auf das Gerüst (Rückgrat) eines anderen Monomers aufgepfropft sind.

Der Begriff "Derivate" im Sinne dieser Anmeldung bezeichnet einen abgeleiteten Stoff ähnlicher Struktur zu einer entsprechenden Grundsubstanz. Derivate sind Stoffe, deren Moleküle an Stelle eines H-Atoms oder einer funktionellen Gruppe ein anderes Atom oder eine andere Atomgruppe besitzen bzw. bei denen ein oder mehrere Atome/Atomgruppen entfernt wurden.

Der Begriff "Polymer(e)" im Sinne dieser Anmeldung bedeutet Monomer(e), Oligomer(e), Polymer(e), Copolymer(e), Blockcopolymer(e), Pfropfcopolymer(e), deren Gemische und deren Compoundierungen auf organischer oder/und im Wesentlichen organischer Basis. Üblicherweise liegt/liegen die "Polymer(e)" im Sinne dieser Anmeldung vorwiegend oder gänzlich als Polymer(e) oder/und Copolymer(e) vor.

Besonders bevorzugt ist das erfindungsgemäße Verfahren eines, bei dem die wässerige Zusammensetzung oder/und die hieraus hergestellte organische Beschichtung einen Gehalt an filmbildenden Bindemitteln auf Basis von Polyacrylaten, Polyurethanen, Polyepoxiden und/oder deren Hybriden aufweist. Sogenannte Polyacrylat-Polyurethan Hybridharze können vom Typ unterschieden werden in Hybridsysteme, die durch reines Vermischen der verschiedenen Dispersionen erzeugt werden (Blends oder Formulierungen), in solche, die eine chemische Verbindung zwischen den unterschiedlichen Polymerarten aufweisen und in solche, in denen die unterschiedlichen Polymerklassen interpenetrierende Netzwerke (IPN) ausbilden.

Üblicherweise werden solche Polyurethan-Polyacrylat-Hybriddispersionen durch Emulsionspolymerisation eines Vinylpolymerisats ("Polyacrylat") in einer wässrigen Polyurethandispersion hergestellt. Es ist aber auch möglich, die Polyurethan-Polyacrylat-Hybriddispersion als Sekundärdispersion herzustellen.

Wässrige Polyacrylat-Polyepoxid Hybriddispersionen werden üblicherweise durch Additionsreaktionen eines bifunktionellen Epoxids mit bifunktionellen Aminmonomerbausteinen und anschließender Reaktion mit einem Polyacrylat mit ausreichenden Carboxylfunktionen hergestellt. Die Wasserdispergierbarkeit kann wie bei den Polyurethansekundärdispersionen dabei z.B. durch Carboxylatgruppen, die mit Aminen in anionische Gruppen überführt wurden und anschließender Dispergierung in Wasser erzielt werden.

Hybriddispersionen zur Ausbildung einer Schicht auf dem Substrat können neben Polyurethan- und Polyepoxid-Bestandteilen bevorzugt auch organische Polymere und/oder Copolymere auf Basis von Polyvinylalkoholen, Polyvinylacetaten Polybutylacrylaten und/oder anderen Acrylsäureester enthalten. Acrylsäureester sind Ester, die sich von der Acrylsäure (CH₂=CH-COOH) ableiten und damit die funktionelle Gruppe (CH₂=CH-COOR) tragen. In großen Mengen werden unter anderem Acrylsäuremethylester, Acrylsäureethylester, Acrylsäurebutylester und Ethylhexylacrylat produziert. Die Hauptanwendung von Acrylsäureestern liegt in Homo- und Copolymeren, die z. B. Acrylsäure, Acrylamiden, Methacrylaten, Acrylnitril, Fumarsäuren, Itaconsäure, Maleaten, Vinylacetat, Vinlychlorid, Styrol, Butadien und ungesättigten Polyestern, Polyepoxidestern, Polyacrylamiden, Polyacrylsäuren, Polycarbonaten, Polyestern, Polyethern, Polystyrolbutadienen, Poly(meth)acrylsäureestern, Polyinylacetatcopolymeren mit Acrylsäureestern und/oder Copolymeren mit Dibutylmaleinat und/oder mit Vinylestern von mindestens einer Koch-Säure, Polyethylenen, Polyvinylchloriden, Polyacrylnitrilen, Polyepoxiden, Polyurethanen, Polyacrylaten, Polymethacrylaten, Polyestern, Polyamiden, Polytetrafluorethylenen, Polyisobutadienen, Polyisoprenen, Silikonen, Silikonkautschuken und/oder deren Derivaten enthalten. Diese sind insbesondere zu mindestens 50 Gew.-% der Fest- und Wirkstoffe in der wässerigen Zusammensetzung enthalten.
Der Begriff "Vorbehandlung" bedeutet eine Behandlung (= Kontaktieren der zu beschichtenden Oberflächen mit einer üblicherweise flüssigen Zusammensetzung), bei der anschließend, gegebenenfalls nach einem nachfolgenden Beschichten, eine weitere Beschichtung zum Schützen der Schichtabfolge und des Gegenstandes wie z.B. mindestens ein Lack aufgebracht wird.

Bei einer vorherigen Vorbehandlung vor einer Aktivierung einer Oberfläche mit einem Aktivierungsmittel, das helfen soll, die Oberfläche elektrostatisch aufzuladen, können die zu behandelnden Oberflächen bei Bedarf zuerst alkalisch gereinigt und gegebenenfalls mit einer Zusammensetzung zur Vorbehandlung kontaktiert werden, letzteres insbesondere um eine Konversionsschicht auszubilden. Dann können die derart behandelten oder/und beschichteten Oberflächen gegebenenfalls mit einem Primer oder/und mit einer gegebenenfalls umformbaren Schutzschicht, insbesondere mit einem Korrosionsschutzprimer, beschichtet oder/und gegebenenfalls beölt werden. Die Beölung dient insbesondere dem vorübergehenden Schutz der behandelten oder/und beschichteten insbesondere metallischen Oberflächen.

Als Vorbehandlung ist grundsätzlich jede Art der Vorbehandlung möglich: Es können beispielsweise wässerige Vorbehandlungszusammensetzungen auf Basis von Phosphat, Phosphonat, Silan/Silanol/Siloxan/Polysiloxan, Lanthanidverbindung, Titanverbindung, Hafniumverbindung, Zirkoniumverbindung Säure, Metallsalz oder/und organischem Polymer eingesetzt werden.

Bei der weiteren Behandlung dieser beschichteten Substrate kann bei Bedarf unabhängig davon, ob davor Öl aufgebracht worden ist oder nicht, eine insbesondere alkalische Reinigung erfolgen.

Eine Beschichtung mit einem Korrosionsschutzprimer wie z.B. einem Schweißprimer kann zusätzlichen Korrosionsschutz insbesondere in Hohlräumen und schlecht zugänglichen Partien eines Substrats, Umformbarkeit oder/und Fügbarkeit z.B. beim Falzen, Kleben oder/und Schweißen ermöglichen. In der industriellen Praxis könnte ein Korrosionsschutzprimer insbesondere dann eingesetzt werden, wenn das damit beschichtete Substrat wie z.B. ein Blech nach der Beschichtung mit dem Korrosionsschutzprimer geformt oder/und mit einer weiteren Komponente gefügt wird und wenn weitere Beschichtungen erst danach aufgebracht werden. Wenn in diesem Verfahrensgang zusätzlich ein Korrosionsschutzprimer unter der Aktivierungsschicht und unter der Polymerbeschichtung aufgebracht wird, wird üblicherweise ein deutlich verbesserter Korrosionsschutz erzeugt.

Der Begriff "im Wesentlichen spülfest" im Sinne dieser Anmeldung bedeutet, dass unter den Bedingungen der jeweiligen Anlage und Verfahrensabfolge die jeweils letzte Beschichtung durch einen Spülvorgang (= Spülen) nicht gänzlich entfernt wird, so dass eine Beschichtung hergestellt werden kann, vorzugsweise eine geschlossene Beschichtung.

Bei dem erfindungsgemäßen Verfahren können als Partikel die unterschiedlichsten Partikelarten, Partikelgrößen und Partikelformen verwendet werden.

Als Partikel in der wässerigen Zusammensetzung zum Ausbilden der Schicht können vorzugsweise Oxide, Hydroxide, Carbonate, Phosphate, Phosphosilicate, Silicate, Sulfate, organische Polymere inklusive Copolymeren und deren Derivaten, Wachse und/oder compoundierte Partikel, insbesondere solche auf Basis von Korrosionsschutzpigmenten, organischen Polymeren, Wachsen und/oder compoundierten Partikeln, verwendet werden und/oder deren Gemische. Sie weisen vorzugsweise Partikelgrößen auf im Bereich von 5 nm bis 15 µm, von 8 nm bis 5 µm, oder von 15 nm bis 1,5 µm, insbesondere von 30 nm bis 700 nm oder von 50 nm bis 500 nm. Sie sind vorzugsweise wasserunlösliche Partikel.

Compoundierte Partikel weisen in einem Partikel ein Gemisch von mindestens zwei verschiedenen Substanzen auf. Compoundierte Partikel können oft andere Substanzen mit sehr unterschiedlichen Eigenschaften aufweisen. Sie können beispielsweise teilweise oder gänzlich die Zusammensetzung für einen Lack enthalten, gegebenenfalls sogar mit einem Gehalt an nichtpartikulär ausgebildeten Substanzen wie z.B. Tensid, Entschäumer, Dispergiermittel, Lackhilfsmittel, weitere Arten Additive, Farbstoff, Korrosionsinhibitor, schwach wasserlöslichem Korrosionsschutzpigment oder/und andere Substanzen, die für entsprechende Mischungen üblich oder/und bekannt sind. Solche Lackbestandteile können beispielsweise für organische Beschichtungen zum Umformen, für Korrosionsschutzprimer und andere Primer, für Farblacke, Füller oder/und Klarlacke geeignet oder/und häufig genutzt sein.

Ein Korrosionsschutzprimer weist üblicherweise elektrisch leitfähige Partikel auf und ist elektrisch schweißbar. Generell ist es hierbei vielfach bevorzugt, dass a) ein Gemisch chemisch oder/und physikalisch verschiedenartiger Partikel, b) Partikel, Aggregate oder/und Agglomerate aus chemisch oder/und physikalisch verschiedenartigen Partikeln oder/und c) compoundierten Partikeln in der Zusammensetzung oder/und in der hieraus gebildeten Partikelschicht verwendet werden.

Vielfach ist es bevorzugt, dass die Partikel enthaltende Zusammensetzung oder/und die hieraus gebildete Partikelschicht neben mindestens einer Art von Partikeln auch mindestens eine nichtpartikuläre Substanz enthält/enthalten, insbesondere Additive, Farbstoffe, Korrosionsinhibitoren oder/und schwach wasserlösliche Korrosionsschutzpigmente. Es können insbesondere als Partikel in der Zusammensetzung oder/und in der hieraus gebildeten Partikelschicht farbige oder/und gegebenenfalls auch ein begrenzter Anteil an elektrisch leitfähigen Partikeln insbesondere auf Basis von Fullerenen und anderen Kohlenstoffverbindungen mit Graphit-ähnlichen Strukturen oder/und Russ, gegebenenfalls auch Nanocontainer oder/und Nanoröhren enthalten sein. Andererseits können hierbei insbesondere als Partikel in der Zusammensetzung oder/und in der hieraus gebildeten Beschichtung beschichtete Partikel, chemisch oder/und physikalisch modifizierte Partikel, Kern-Schale-Partikel, compoundierte Partikel aus verschiedenartigen Substanzen, verkapselte Partikel oder/und Nanocontainer verwendet werden.

Bei dem erfindungsgemäßen Verfahren ist es bevorzugt, dass die Partikel enthaltende Zusammensetzung, die hieraus gebildete Partikelschicht oder/und die hieraus z.B. durch Verfilmen oder/und Vernetzen gebildete Beschichtung neben mindestens einer Art von Partikeln auch jeweils mindestens einen Farbstoff, ein Farbpigment, ein Korrosionsschutzpigment, einen Korrosionsinhibitor, ein Leitfähigkeitspigment, eine weitere Art an Partikeln, ein Silan/Silanol/Siloxan/ Polysiloxan/Silazan/Polysilazan, ein Lackadditiv oder/und ein Additiv wie z.B. jeweils mindestens ein Tensid, einen Entschäumer oder/und ein Dispergiermittel, enthält/enthalten.

Bei dem erfindungsgemäßen Verfahren ist es bevorzugt, dass die Zusammensetzung oder/und die hieraus gebildete Beschichtung neben mindestens einer Art von Partikeln und gegebenenfalls neben mindestens einer nicht-partikulären Substanz teilweise oder vollständig eine chemische Zusammensetzung für einen Primer, einen Lack wie beispielsweise für einen Füller, Decklack oder/und Klarlack aufweist.

Als Zusätze zu den organischen Polymeren der Partikel empfehlen sich in vielen Ausführungsformen Pigmente oder/und Additive, wie sie in Lacken oder/und Primern häufig verwendet werden.

Eine Filmbildung lässt sich durch den Einsatz thermoplastischer Polymere oder/und durch Zusatz von Substanzen, die als temporäre Weichmacher dienen, verbessern. Filmbildungshilfsmittel wirken als spezifische Lösemittel, die die Oberfläche der Polymerteilchen erweichen und so deren Verschmelzung ermöglichen. Hierbei ist vorteilhaft, wenn diese Weichmacher einerseits ausreichend lange in der wässerigen Zusammensetzung bleiben, um sich auf die Polymerteilchen lange auswirken zu können, und danach verdampfen und somit aus dem Film entweichen. Ferner ist es vorteilhaft, wenn auch ausreichend lange während des Trockenprozesses ein Restwassergehalt vorhanden ist.

Insbesondere vorteilhaft als Filmbildungshilfsmittel sind sogenannte langkettige Alkohole, insbesondere solche mit 4 bis 20 C-Atomen,
wie Butandiol,
Butylglykol,
Butyldiglykol,
Ethylenglykolether wie Ethylenglykolmonobutylether,
Ethylenglykolmonoethylether,
Ethylenglykolmonomethylether,
Ethylglykolpropylether,
Ethylenglykolhexylether,
Diethylenglykolmethylether,
Diethylenglykolethylether,
Diethylenglykolbutylether,
Diethylenglykolhexylether oder ein
Polypropylenglykolether wie
Propylenglykolmonomethylether,
Dipropylenglykolmonomethylether,
Tripropylenglykolmonomethylether,
Propylenglykolmonobutylether,
Dipropylenglykolmonobutylether,
Tripropylenglykolmonobutylether,
Propylenglykolmonopropylether,
Dipropylenglykolmonopropylether,
Tripropylenglykolmonopropylether,
Propylenglykolphenylether,
Trimethylpentandioldiisobutyrat,
Polytetrahydrofuran,
Polyetherpolyol oder/und Polyesterpolyol.

Eine Vernetzung kann beispielsweise mit bestimmten reaktiven Gruppen wie z.B. Isocyanat-, Isocyanurat-, Phenol- oder/und Melamingruppen erfolgen.

Vorzugsweise wird die Folgebeschichtung in einer Weise getrocknet, dass insbesondere vorhandene organische Polymerpartikel verfilmen können, so dass eine weitgehend oder vollständig homogene Beschichtung gebildet wird. Die Trockentemperaturen können dabei in manchen Ausführungsformen so hoch gewählt werden, dass die organischen polymeren Bestandteile vernetzen können.

Bei dem erfindungsgemäßen Verfahren ist es in etlichen Ausführungsformen bevorzugt, dass eine im Wesentlichen organische Partikel enthaltende Partikelschicht ausgebildet und beispielsweise beim Trocknen verfilmt oder/und vernetzt wird. Das Verfilmen erfolgt in manchen Ausführungsformen auch ohne Anwesenheit von Filmbildungshilfsmitteln. Hierbei können die Partikel der Beschichtung, insbesondere wenn sie vorwiegend oder gänzlich als organische Polymere vorliegen, vorzugsweise zu einem im Wesentlichen geschlossenen oder zu einer geschlossenen Beschichtung verfilmt werden, insbesondere beim Trocknen. Hierbei ist es oft bevorzugt, dass die Trocknungstemperatur einer Beschichtung, die vorwiegend oder gänzlich aus organischen Polymeren bestehen, so gewählt wird, dass eine im Wesentlichen geschlossene oder eine geschlossene Beschichtung gebildet wird. Bei Bedarf kann zum Verfilmen mindestens ein Filmbildungshilfsmittel zugesetzt werden, insbesondere auf Basis von mindestens einem langkettigen Alkohol. Bei Ausführungsformen mit mehreren Partikelschichten übereinander werden vorzugsweise erst alle Partikelschichten aufgebracht und danach gemeinsam verfilmt oder/und vernetzt.

Der Gehalt an mindestens einem Filmbildungshilfsmittel kann in der wässerigen Zusammensetzung - insbesondere im Bad - vorzugsweise 0,01 bis 50 g/L bezogen auf Feststoffe einschließlich Wirkstoffen, besonders bevorzugt 0,08 bis 35 g/L, ganz besonders bevorzugt 0,2 bis 25 g/L, insbesondere 1 bis 12 g/L betragen. Das Gewichtsverhältnis der Gehalte an organischem Filmbildner zu Gehalten an Filmbildungshilfsmitteln in der wässerigen Zusammensetzung - insbesondere im Bad - kann in weiten Bereichen schwanken; insbesondere kann es bei ≤ (100 : 0,1) liegen. Vorzugsweise liegt dieses Verhältnis im Bereich von 100 : 10 bis 100 : 0,2, besonders bevorzugt im Bereich von 100 : 2 bis 100 : 0,75.

Hierbei ist es vielfach bevorzugt, dass das Trocknen, Verfilmen oder/und Vernetzen im Temperaturbereich von 50 bis 260°C erfolgt, besonders bevorzugt im Temperaturbereich von 120 bis 220°C bezogen auf die Ofentemperatur oder/und bezogen auf Peak-Metal-Temperature (PMT). Der gewählte Temperaturbereich ist weitgehend von der Art und Menge der organischen und gegebenenfalls auch der anorganischen Bestandteile und gegebenenfalls auch von ihren Filmbildungstemperaturen oder/und Vernetzungstemperaturen abhängig.

Vorzugsweise betrifft die Erfindung ein Verfahren, bei dem die wässerige Zusammensetzung oder/und die hieraus hergestellte organische Beschichtung einen Gehalt an mindestens einem Komplexbildner für Metallkationen oder einem Polymer, welches Metallkationen komplexierend modifiziert ist, aufweist.

Besonders bevorzugt ist das erfindungsgemäße Verfahren eines, bei dem die wässerige Zusammensetzung oder/und die hieraus hergestellte organische Beschichtung einen Gehalt an mindestens einem Komplexbildner ausgewählt aus solchen auf Basis von Maleinsäure, Alendronsäure, Itaconsäure, Citraconsäure oder Mesaconsäure oder die Anhydride oder Halbester dieser Carbonsäuren aufweist.

Vorteilhafter Weise weist die wässerige Zusammensetzung oder/und die hieraus hergestellte organische Beschichtung einen Gehalt an mindestens einem Emulgator auf.

Besonders bevorzugt ist, dass die wässerige Zusammensetzung oder/und die hieraus hergestellte organische Beschichtung einen Gehalt an mindestens einem Emulgator ausgewählt aus solchen auf Basis von anionischen Emulgatoren aufweist.

Vorzugsweise enthält die wässerige Zusammensetzung oder/und die hieraus hergestellte organische Beschichtung ein Gemisch aus mindestens zwei verschiedenen anionischen Polyelektrolyten.

Besonders bevorzugt enthält die wässerige Zusammensetzung oder/und die hieraus hergestellte organische Beschichtung ein Gemisch aus zwei Pektinen.

Weiterhin bevorzugt enthält die wässerige Zusammensetzung oder/und die hieraus hergestellte organische Beschichtung als Gelbildner mindestens ein anionisches Polysaccharid ausgewählt aus solchen mit einem Veresterungs- und/oder Amidierungsgrad der Carboxyfunktion im Bereich von 5 bis 75 % bezogen auf die Gesamtzahl der Alkohol- und Carboxygruppen.

Ganz besonders bevorzugt enthält die wässerige Zusammensetzung oder/und die hieraus hergestellte organische Beschichtung als Gelbildner mindestens ein anionisches Polysaccharid oder/und mindestens einen anionischen Polyelektrolyten ausgewählt aus solchen, mit einem Molekulargewicht im Bereich von 500 bis 1000000 g/mol⁻¹.

Besonders bevorzugt ist in dem erfindungsgemäßen Verfahren, dass die anionischen Polyelektrolyte modifiziert werden oder modifiziert sind mit Haftung vermittelnden Haftgruppen ausgewählt aus der Gruppe bestehend aus chemischen Gruppen von multifunktionalen Epoxiden, Isocyanaten, primären Aminen, sekundären Aminen, tertiären Aminen, quartären Aminen, Amiden, Imiden, Imidazolen, Formamiden, Michael-Reaktionsprodukten, Carbodiimiden, Carbenen, cyclischen Carbenen, Cyclocarbonaten, multifunktionalen Carbonsäuren, Aminosäuren, Nukleinsäuren, Methacrylamiden, Polyacrylsäuren, Polyacrylsäurederivaten, Polyvinylalkoholen, Polyphenolen, Polyolen mit mindestens einem Alkyl- und/oder Arylrest, Caprolactam, Phosphorsäuren, Phosphorsäureestern, Epoxidestern, Sulfonsäuren, Sulfonsäureestern, Vinylsulfonsäuren, Vinylphosphonsäuren, Katechol, Silanen sowie den hieraus gebildeten Silanolen und/oder Siloxanen, Triazinen, Thiazolen, Thiazinen, Dithiazinen, Acetalen, Halbacetalen, Chinonen, gesättigten Fettsäuren, ungesättigten Fettsäuren, Alkyden, Estern, Polyestern, Ethern, Glykolen, cyclischen Ethern, Kronenethern, Anhydriden, sowie von Acetylacetonen und von beta-Diketo-Gruppen, Carbonylgruppen und Hydroxy-Gruppen.

Vorteilhafter Weise werden als Kationen, die aus der silikatischen Schicht herausgelöst oder/und die der wässerigen Zusammensetzung zur Einlagerung in die silikatische Schicht zugesetzt werden, Ag, Al, Cu, Fe, Mg oder/und Zn ausgewählt. Die wässerige Zusammensetzung enthält vorzugsweise weiterhin einen Vernetzer ausgewählt aus der Gruppe bestehend aus: Silanen, Siloxanen, Phenolharztypen oder Aminen in einer Menge von 0,01 g/L bis 50 g/L.

Besonders bevorzugt enthält die wässerige Zusammensetzung einen Vernetzer ausgewählt aus der Gruppe besteht aus: Silanen, Siloxanen, Phenolharztypen oder Aminen in einer Menge von 0,01 g/L bis 50 g/L.

In weiterer Ausgestaltung der Erfindung enthält die wässerige Zusammensetzung komplexe Titan- und /oder Zirkonfluoride in einer Menge von 0,01 g/L bis 50 g/L.

Besonders bevorzugt enthält die wässerige Zusammensetzung komplexe Titan- und /oder Zirkonfluoride in einer Menge von 0, 1 g/L bis 30 g/L.

Ganz besonders bevorzugt enthält die wässerige Zusammensetzung oder/und die hieraus hergestellte organische Beschichtung weiterhin mindestens ein Additiv ausgewählt aus Additiven bestehend aus der Gruppe von Entschäumern, Bioziden, Dispergierhilfsmitteln, Filmbildungshilfmitteln, saure oder/und basische Hilfsmittel zum Einstellen des pH-Werts und Verdicker und Verlaufsmittel.

Ganz besonders bevorzugt werden vor dem Kontaktieren und Beschichten der metallischen Oberflächen mit einer wässerigen Zusammensetzung in Verfahrensstufe II. die metallischen Oberflächen gereinigt, gebeizt oder/und vorbehandelt.

Vorteilhafter Weise bildet die wässerige Zusammensetzung eine Beschichtung auf Basis eines ionogenen Gels aus, bei dem der dabei oder später ausgebildete Trockenfilm eine Dicke von mindestens 1 µm aufweist.

Besonders bevorzugt wird die organische Beschichtung in 0,05 bis 20 Minuten im Tauchbad ausgebildet und weist nach dem Trocknen eine Trockenfilmdicke im Bereich von 5 bis 100 µm auf.

In dem erfindungsgemäßen Verfahren Verwendung finden kann weiterhin eine wässerige Zusammensetzung, enthaltend 30 bis 80 Gew.-% mindestens eines nichtionisch stabilisierten Bindemittels und 0,001 bis 20,0 Gew.-% eines Gelbildners, wobei die wässerige Zusammensetzung einen pH-Wert im Bereich von 0,5 bis 7 aufweist.

Vorzugsweise ist die wässrige Zusammensetzung eine die in der Dispersion aus filmbildenden Polymeren einen Gehalt an organischen Partikeln auf Basis von Polyacrylaten, Polyurethanen, Polyepoxiden und/oder deren Hybriden, einen Gehalt an mindestens einem Komplexbildner ausgewählt aus solchen auf Basis von Maleinsäure, Alendronsäure, Itaconsäure, Citraconsäure oder Mesaconsäure oder Anhydriden oder Halbestern dieser Carbonsäuren und mindestens einen anionischen Polyelektrolyten auf Basis von Pektinen oder Gellan Gum aufweist.

Es hat sich gezeigt, dass aus den erfindungsgemäß beschichteten Oberflächen anschließend im Wesentlichen geschlossene oder geschlossene Beschichtungen mit einer Schichtdicke im Bereich von 1 µm bis 250 µm hergestellt werden können, insbesondere im Bereich von 3 µm bis 100 µm oder von 5 µm bis 50 µm. Entsprechende Schichtdicken können die einzelnen Beschichtungen vor oder/und nach ihrer Verfilmung oder/und vor ihrer Vernetzung aufweisen.

Es hat sich gezeigt, dass die erfindungsgemäß beschichteten Oberflächen, aus denen anschließend im Wesentlichen geschlossene oder geschlossene Beschichtungen hergestellt wurden, auf deutlich einfachere und deutlich kostengünstigere Weise hergestellt werden konnten als beispielsweise Elektrotauchlack-, autophoretischen Tauchlack- oder Pulverlackbeschichtungen.

Ferner hat es sich gezeigt, dass derartige erfindungsgemäß hergestellte Beschichtungen Elektrotauchlack-, autophoretischen Tauchlack- oder Pulverlackbeschichtungen der heutigen industriellen Praxis in ihren Eigenschaften gleichwertig sein können, wenn entsprechend chemisch zusammengesetzte, insbesondere Formulierungen eingesetzt werden.

Es wurde überraschend festgestellt, dass das erfindungsgemäße Verfahren, das kein oder im Wesentlichen kein elektrolytisches Verfahren ist, auch in dem Fall, dass es mit elektrischer Spannung geringfügig unterstützt wird, und es daher üblicherweise kein Anlegen einer äußeren elektrischen Spannung bedarf, in einfacher Weise und ohne aufwendige Steuerung betrieben werden kann. Dieses Verfahren kann in einem weiten Temperaturbereich und auch bei Raumtemperatur eingesetzt werden, wenn von der nachfolgenden Trocknung abgesehen wird.

Es wurde überraschend festgestellt, dass bei dem erfindungsgemäßen Verfahren bezüglich der Aufbringung des Aktivierungsmittels keine aufwendigen Steuerungsmaßnahmen erforderlich sind, um eine gleichmäßige und homogene Beschichtung zu erzielen, und dass bei geringem Chemikalienverbrauch hochwertige schützende Folgebeschichtungen gebildet werden, die eine Dicke im Bereich von 500 nm bis 30 µm erreichen.

Es wurde überraschend festgestellt, dass es sich bei dem erfindungsgemäßen Verfahren bezüglich der Abscheidung insbesondere der Folgebeschichtung um ein selbstregulierendes Verfahren handelt, bei dem keine aufwendigen Steuermaßnahmen erforderlich sind und bei geringem Chemikalienverbrauch hochwertige schützende Beschichtungen gebildet werden.

Es wurde überraschend festgestellt, dass die erfindungsgemäß abgeschiedenen Folgebeschichtungen eine homogene Schicht mit einer gleichmäßigen Trockenschichtdicke auf einem komplex geformten Werkstück ausbildeten, vergleichbar mit der Qualität einer herkömmlich elektrophoretisch oder autophoretisch abgeschiedenen Lackschicht.

Die erfindungsgemäße Beschichtung kann vorzugsweise eingesetzt werden für beschichteten Substrate als Draht, Drahtgeflecht, Band, Blech, Profil, Verkleidung, Teil eines Fahrzeugs oder Flugkörpers, Element für ein Haushaltsgerät, Element im Bauwesen, Gestell, Leitplanken-, Heizkörper- oder Zaunelement, Formteil komplizierter Geometrie oder Kleinteil wie z.B. Schraube, Mutter, Flansch oder Feder. Besonders bevorzugt wird sie im Automobilbau, im Bauwesen, für den Gerätebau, für Haushaltsgeräte oder im Heizungsbau eingesetzt. Die Verwendung des erfindungsgemäßen Verfahrens ist besonders bevorzugt zur Beschichtung von Substraten, die Probleme bei der Beschichtung mit einem Elektrotauchlack bereitet haben.

### Beispiele

I. Substrate:
   1 Kaltgewalzter, durchlaufgeglühter Stahl ohne weitere Legierungsbestandteile nach DIN EN 10130 und mit einer Blechdicke von etwa 0,7 - 0,8 mm.
   2 Elektrolytisch verzinkter Stahl nach DIN EN 10153 und mit einer Zinkauflage von 75 g/m² sowie einer Blechdicke von etwa 0,7 - 0,8 mm.
   3 Aluminium als AlMgSi-Legierung entsprechend der Norm AA 6014 und mit einer Blechdicke von etwa 1,2 mm.
   4 Stab aus Buchenholz
II. Reinigung:
   Die Substrate werden mit einem alkalischen Standardreiniger der Firma Chemetall gereinigt, welcher aus 30 g/L Gardoclean® S5176 und 4 g/L Gardobond® Additive H7406 in Stadtwasser besteht. Mit Gardobond® Additive H7143 stellt man auf pH 10,5 - 10,8 ein. Die Reinigung erfolgt im Spritzen für 3 Minuten bei 60 °C und 0,6 bar. Anschließend werden die Bleche gründlich mit Stadtwasser und vollentsalztem Wasser im Tauchen gespült.
III. Silikatbeschichtung:
   Zur Herstellung der silikatbasierten Vorbehandlung werden einer Vorlage aus vollentsalztem Wasser 2,9 g/L Gardobond® Additive H7107 und 22 g/L Gardobond® Oxsilan® Additive 9906 der Firma Chemetall zugegeben. Danach stellt man auf etwa pH 4,5 mit Gardobond® Oxsilan® Additive 9951 ein und fügt 125 g/L Snowtex® O der Firma Nissan Chemical hinzu. Am Ende wird mit vollentsalztem Wasser aufgefüllt und das Bad mit verdünnter Salpetersäure auf pH 4,0 gebracht.
   Um mehrwertige Kationen in die Silikatbeschichtung einzubauen, müssen diese beim Ansetzen der Vorlage aus vollentsalztem Wasser zugesetzt werden, bevor alle übrigen Bestandteile (siehe oben) folgen.
   Die Substrate werden bei 40 °C für die in den Beispielen genannte Zeit im Tauchbad behandelt und hinterher, sofern keine anderslautende Dauer angegeben ist, gründlich für 2 Minuten bei Raumtemperatur in vollentsalztem Wasser gespült. Zusätzlich können die in dieser Form hergestellten Beschichtungen optional vorder folgenden Behandlung getrocknet werden ohne die Reaktivität für den folgenden Beschichtungsschritt zu verlieren.
IV. Abscheidung organischer Formulierung:
   Die behandelten Substrate werden bei Raumtemperatur für die in den Beispielen genannte Dauer in eine organische Formulierung, welche gemäss der Schrift WO002013117611A1 auf der ionogenen Gelbildung beruht, um zu prüfen ob die Metallkationen in der Silikatbeschichtung ausreichen diese abzuscheiden.
   Anschliessend werden die beschichteten Substrate in vollentsalztem Wasser gründlich gespült. Die Trocknung der Beschichtung erfolgt im Umluftofen für 5 Minuten bei 170 °C. Die Beurteilung der resultierenden Stärke der Gesamtbeschichtung erfolgt über Wirbelstrommessung oder gravimetrisch.
V. Röntgenfluoreszenzanalyse:
   Zur Charakterisierung der Silikatbeschichtung wird die Röntgenfluoreszenzanalyse verwendet. Der Gehalt an Silicium und Zirkon lässt Rückschlüsse auf die Schichtdicke zu, während Calcium, Magnesium oder Zink über die Menge an eingebauten Kationen in der Schicht informieren.

### Generelle Versuchsbeschreibung:

Die Substrate 1 bis 3 wurden gemäß Punkt II. mit einem alkalischen Spritzreiniger vorbehandelt, einer silikatbasierten Vorbehandlung gemäß Punkt III. unterzogen und anschließend mit der gemäß Punkt IV. angegebenen organischen Formulierung beschichtet.

### Vergleichsbeispiel 1

Substrat 1 wurde ohne Silikatbeschichtung und Metallioneneinlagerung gemäß Punkt III. mit der gemäß Punkt IV. angegebenen organischen Formulierung durch Tauchen für 5 Minuten in das Tauchbad beschichtet. Es wurde eine Trockenfilmstärke von 20 µm mit einem Wirbelstrom-Messgerät und ermittelt.

### Vergleichsbeispiel 2

Substrat 2 wurde ohne Silikatbeschichtung und Metallioneneinlagerung gemäß Punkt III. mit der gemäß Punkt IV. angegebenen organischen Formulierung durch Tauchen für 5 Minuten in das Tauchbad beschichtet. Es wurde eine Trockenfilmstärke von 41 µm mit einem Wirbelstrom-Messgerät ermittelt.

### Vergleichsbeispiel 3

Substrat 3 wurde ohne Silikatbeschichtung und Metallioneneinlagerung gemäß Punkt III. mit der gemäß Punkt IV. angegebenen organischen Formulierung durch Tauchen für 5 Minuten in das Tauchbad beschichtet. Es wurde keine Trockenfilmstärke mit einem Wirbelstrom-Messgerät ermittelt.

### Vergleichsbeispiel 4

Substrat 3 wurde eine silikatbasierte Vorbehandlung gemäß Punkt III. ohne Zusatz von Metallsalzen für fünf Minuten vorgenommen und anschließend mit der gemäß Punkt IV. angegebenen organischen Formulierung für 5 Minuten beschichtet. Es wurde keine Trockenfilmstärke mit einem Wirbelstrom-Messgerät und Flächengewichte von 622 mg/m² Silicium sowie 55 mg/m² Zirkon mittels Röntgenfluoreszenzanalyse gemäß Punkt V. ermittelt.

### Beispiel 1

Substrat 1 wurde eine silikatbasierte Vorbehandlung gemäß Punkt III. unter Zusatz von 24 g/L Calciumnitrat Tetrahydrat für fünf Minuten vorgenommen und anschließend mit der gemäß Punkt IV. angegebenen organischen Formulierung für 5 Minuten beschichtet. Es wurde eine Trockenfilmdicke von 22 µm gemessen mit einem Wirbelstrom-Messgerät und Flächengewichte von 945 mg/m² Silicium, 10 mg/m² Zirkon sowie 5 mg/m² Calcium mittels Röntgenfluoreszenzanalyse gemäß Punkt V. ermittelt.

### Beispiel 2

Beispiel 1 wurde mit Substrat 2 wiederholt und eine Trockenfilmdicke von 44 µm gemessen mit einem Wirbelstrom-Messgerät und Flächengewichte von 1005 mg/m² Silicium, 12 mg/m² Zirkon sowie 9 mg/m² Calcium mittels Röntgenfluoreszenzanalyse gemäß Punkt V. ermittelt.

### Beispiel 3

Beispiel 1 wurde mit Substrat 3 wiederholt und eine Trockenfilmdicke von 11 µm mit einem Wirbelstrom-Messgerät und Flächengewichte von 1245 mg/m² Silicium, 12 mg/m² Zirkon sowie 10 mg/m² Calcium mittels Röntgenfluoreszenzanalyse gemäß Punkt V. ermittelt.

### Beispiel 4

Substrat 3 wurde eine silikatbasierte Vorbehandlung gemäß Punkt III. unter Zusatz von 47 g/L Calciumnitrat Tetrahydrat für fünf Minuten vorgenommen und anschließend mit der gemäß Punkt IV. angegebenen organischen Formulierung für 5 Minuten beschichtet. Es wurde eine Trockenfilmdicke von 10 µm gemessen mit einem Wirbelstrom-Messgerät und Flächengewichte von 1505 mg/m² Silicium, 12 mg/m² Zirkon sowie 5 mg/m² Calcium mittels Röntgenfluoreszenzanalyse gemäß Punkt V. ermittelt.

### Beispiel 5

Beispiel 4 wurde wiederholt mit dem Unterschied, dass 71 g/L Calciumnitrat Tetrahydrat eingesetzt wurden und eine Trockenfilmdicke von 9 µm gemessen mit einem Wirbelstrom-Messgerät sowie Flächengewichte von 965 mg/m² Silicium, 8 mg/m² Zirkon und 5 mg/m² Calcium mittels Röntgenfluoreszenzanalyse gemäß Punkt V. ermittelt wurden.

### Beispiel 6

Beispiel 4 wurde wiederholt mit dem Unterschied, dass 95 g/L Calciumnitrat Tetrahydrat eingesetzt wurden und eine Trockenfilmdicke von 2 µm gemessen mit einem Wirbelstrom-Messgerät sowie Flächengewichte von 116 mg/m² Silicium, 2 mg/m² Zirkon und < 5 mg/m² Calcium mittels Röntgenfluoreszenzanalyse gemäß Punkt V. ermittelt wurden.

### Beispiel 7

Substrat 3 wurde einer silikatbasierten Vorbehandlung gemäß Punkt III. unter Zusatz von 26 g/L Magnesiumnitrat Hexahydrat für fünf Minuten unterzogen und anschließend mit der gemäß Punkt IV. angegebenen organischen Formulierung für 5 Minuten beschichtet. Es wurde eine Trockenfilmdicke von 3 µm gemessen mit einem Wirbelstrom-Messgerät und Flächengewichte von 800 mg/m² Silicium, 60 mg/m² Zirkon sowie 25 mg/m² Magnesium mittels Röntgenfluoreszenzanalyse gemäß Punkt V. ermittelt.

### Beispiel 8

Beispiel 7 wurde wiederholt mit dem Unterschied, dass 103 g/L Magnesiumnitrat Hexahydrat eingesetzt wurden und eine Trockenfilmdicke von 5 µm gemessen mit einem Wirbelstrom-Messgerät und Flächengewichte von 1245 mg/m² Silicium, 18 mg/m² Zirkon sowie 15 mg/m² Magnesium mittels Röntgenfluoreszenzanalyse gemäß Punkt V. ermittelt wurden.

### Beispiel 9

Substrat 3 wurde einer silikatbasierten Vorbehandlung gemäß Punkt III. unter Zusatz von 47 g/L Zinknitrat für fünf Minuten unterzogen und anschließend mit der gemäß Punkt IV. angegebenen organischen Formulierung für 5 Minuten beschichtet. Es wurde eine Trockenfilmdicke von 2 µm gemessen mit einem Wirbelstrom-Messgerät und Flächengewichte von 565 mg/m² Silicium, 82 mg/m² Zirkon sowie 25 mg/m² Zink mittels Röntgenfluoreszenzanalyse gemäß Punkt V. ermittelt.

### Beispiel 10

Beispiel 9 wurde wiederholt mit dem Unterschied, dass 189 g/L Zinknitrat eingesetzt wurden und eine Trockenfilmdicke von 8 µm gemessen mit einem Wirbelstrom-Messgerät und Flächengewichte von 1210 mg/m² Silicium, 78 mg/m² Zirkon sowie 50 mg/m² Zink mittels Röntgenfluoreszenzanalyse gemäß Punkt V. ermittelt wurden.

### Beispiel 11

Beispiel 9 wurde wiederholt mit dem Unterschied, dass 379 g/L Zinknitrat eingesetzt wurden und eine Trockenfilmdicke von 0 µm gemessen mit einem Wirbelstrom-Messgerät und Flächengewichte von 63 mg/m² Silicium, 2 mg/m² Zirkon sowie 25 mg/m² Zink mittels Röntgenfluoreszenzanalyse gemäß Punkt V. ermittelt wurden.

### Beispiel 12

Substrat 3 wurde eine silikatbasierte Vorbehandlung gemäß Punkt III. unter Zusatz von 24 g/L Calciumnitrat Tetrahydrat für eine Minute vorgenommen und anschließend mit der gemäß Punkt IV. angegebenen organischen Formulierung für 5 Minuten beschichtet. Es wurde eine Trockenfilmdicke von 4 µm gemessen mit einem Wirbelstrom-Messgerät und Flächengewichte von 96 mg/m² Silicium, 2 mg/m² Zirkon sowie <5 mg/m² Calcium mittels Röntgenfluoreszenzanalyse gemäß Punkt V. ermittelt.

### Beispiel 13

Beispiel 12 wurde wiederholt mit dem Unterschied, dass die Behandlungsdauer mit Calciumnitrat Tetrahydrat zwei Minuten betrug. Es wurden eine Trockenfilmdicke von 5 µm gemessen mit einem Wirbelstrom-Messgerät sowie Flächengewichte von 300 mg/m² Silicium, 3 mg/m² Zirkon und <5 mg/m² Calcium mittels Röntgenfluoreszenzanalyse gemäß Punkt V. ermittelt.

### Beispiel 14

Beispiel 12 wurde wiederholt mit dem Unterschied, dass die Behandlungsdauer mit Calciumnitrat Tetrahydrat drei Minuten betrug. Es wurden eine Trockenfilmdicke von 13 µm gemessen mit einem Wirbelstrom-Messgerät sowie Flächengewichte von 665 mg/m² Silicium, 6 mg/m² Zirkon und <5 mg/m² Calcium mittels Röntgenfluoreszenzanalyse gemäß Punkt V. ermittelt.

### Beispiel 15

Beispiel 12 wurde wiederholt mit dem Unterschied, dass die Behandlungsdauer mit Calciumnitrat Tetrahydrat vier Minuten betrug. Es wurden eine Trockenfilmdicke von 15 µm gemessen mit einem Wirbelstrom-Messgerät sowie Flächengewichte von 1000 mg/m² Silicium, 8 mg/m² Zirkon und 5 mg/m² Calcium mittels Röntgenfluoreszenzanalyse gemäß Punkt V. ermittelt.

### Beispiel 16

Beispiel 12 wurde wiederholt mit dem Unterschied, dass die Behandlungsdauer mit Calciumnitrat Tetrahydrat zehn Minuten betrug. Es wurden eine Trockenfilmdicke von 20 µm gemessen mit einem Wirbelstrom-Messgerät sowie Flächengewichte von 1690 mg/m² Silicium, 13 mg/m² Zirkon und 10 mg/m² Calcium mittels Röntgenfluoreszenzanalyse gemäß Punkt V. ermittelt.

### Beispiel 17

Beispiel 12 wurde wiederholt mit dem Unterschied, dass die Behandlungsdauer mit Calciumnitrat Tetrahydrat fünf Minuten betrug und anschließend für 60 Minuten mit vollentsalztem Wasser gespült wurde. Es wurden eine Trockenfilmdicke von 15 µm gemessen mit einem Wirbelstrom-Messgerät sowie Flächengewichte von 1470 mg/m² Silicium, 15 mg/m² Zirkon und < 5 mg/m² Calcium mittels Röntgenfluoreszenzanalyse gemäß Punkt V. ermittelt.

### Beispiel 18

Beispiel 3 wurde wiederholt mit dem Unterschied, dass die Behandlungsdauer zur Beschichtung mit der gemäß Punkt IV. angegebenen organischen Formulierung 10 Minuten betrug. Es wurden eine Trockenfilmdicke von 19 µm gemessen mit einem Wirbelstrom-Messgerät sowie Flächengewichte von 1245 mg/m² Silicium, 12 mg/m² Zirkon und 10 mg/m² Calcium mittels Röntgenfluoreszenzanalyse gemäß Punkt V. ermittelt.

### Beispiel 19

Beispiel 18 wurde wiederholt mit dem Unterschied, dass die Behandlungsdauer zur Beschichtung mit der gemäß Punkt IV. angegebenen organischen Formulierung 15 Minuten betrug. Es wurden eine Trockenfilmdicke von 19 µm gemessen mit einem Wirbelstrom-Messgerät sowie Flächengewichte von 1245 mg/m² Silicium, 12 mg/m² Zirkon und 10 mg/m² Calcium mittels Röntgenfluoreszenzanalyse gemäß Punkt V. ermittelt.

### Beispiel 20

Beispiel 18 wurde wiederholt mit dem Unterschied, dass die Behandlungsdauer zur Beschichtung mit der gemäß Punkt IV. angegebenen organischen Formulierung 20 Minuten betrug. Es wurden eine Trockenfilmdicke von 19 µm gemessen mit einem Wirbelstrom-Messgerät sowie Flächengewichte von 1245 mg/m² Silicium, 12 mg/m² Zirkon und 10 mg/m² Calcium mittels Röntgenfluoreszenzanalyse gemäß Punkt V. ermittelt.

### Beispiel 21

Beispiel 1 wurde mit Substrat 4 wiederholt und gravimetrisch eine Trockenfilmdicke von 50 µm ermittelt.

Die mikroskopischen Aufnahmen zeigen durchweg eine homogene Schichtbildung, was auf ein verlässliches, selbst regulierendes und gut kontrollierbares Beschichtungsverfahren hinweist.

## Patentansprüche

1. Verfahren zum Beschichten von metallischen Oberflächen von Substraten umfassend die Schritte oder bestehend aus den Schritten:
I. Bereitstellen eines Substrats mit einer gereinigten Oberfläche,
II. Beschichten mit einer wässerigen Zusammensetzung in Form feiner Dispersion oder/und Suspension aus filmbildenden Polymeren, die aus einem Gemisch mindestens einer stabilisierten Polymer-Dispersion mit einem Feststoffgehalt von 30 bis 80 Gew.-% mit einem Gelbildner in einer Menge von 0,001 bis 20,0 Gew.-% bezogen auf die gesamte Masse des resultierenden Gemisches besteht sowie mit Kationen eine Beschichtung auf Basis eines ionogenen Gels ausbildet;
III. gegebenenfalls Spülen der organischen Beschichtung und
IV. Trocknen oder/und Einbrennen der organischen Beschichtung oder
V. gegebenenfalls Trocknen der organischen Beschichtung und Beschichten mit einer gleichartigen oder weiteren Beschichtungszusammensetzung vor einem Trocknen oder/und Einbrennen,
**dadurch gekennzeichnet,**
**dass** zwischen Schritt I und dem Schritt II eine zusätzliche Beschichtung mit einer wässerigen Zusammensetzung in Form einer Dispersion oder/und Suspension auf der Grundlage eines mehrwertige Metallkationen einlagendernden, kolloidalen silikatischen Sols und gegebenenfalls einem Spülschritt erfolgt, wobei die mehrwertigen Kationen beim Ansetzen der wässerigen Zusammensetzung aus vollentsalztem Wasser zugesetzt werden, bevor die übrigen Bestandteile 2,9 g/L Gardobond® Additive H7107 und 22 g/L Gardobond® Oxsilan® Additive 9906 der Firma Chemetall eingestellt auf etwa pH 4,5 mit Gardobond® Oxsilan® Additive 9951 und 125 g/L Snowtex® O der Firma Nissan Chemical zugesetzt werden.

2. Verfahren nach Anspruch 1, **dadurch gekennzeichnet, dass** der Gelbildner **a)** mindestens ein Polysaccharid auf Basis von Glykogenen, Amylosen, Amylopektinen, Callosen, Agar, Alginen, Alginaten, Pektinen, Carrageenen, Cellulosen, Chitinen, Chitosanen, Curdlanen, Dextranen, Fruktanen, Kollagenen, Gellan Gum, Gummi Arabicum, Stärken, Xanthanen, Traganth, Karayanen, Tarakernmehlen und Glucomannanen; **b)** mindestens ein anionischen Polyelektrolyten natürlichen Ursprungs auf Basis von Polyaminosäuren, Kollagenen, Polypeptiden, Ligninen und/oder **c)** mindestens einen synthetischen anionischen Polyelektrolyten auf Basis von Polyaminosäuren, Polyacrylsäuren, Polyacrylsäuren-Copolymere, Acrylamid-Copolymere, Ligninen, Polyvinylsulfonsäure, Polycarbonsäuren, Polyphosphorsäuren oder Polystyrolen enthält oder daraus besteht.

3. Verfahren nach Anspruch 1 oder 2, **dadurch gekennzeichnet, dass** der Gelbildner mindestens ein Polysaccharid auf Basis von Pektinen oder Gellan Gum enthält oder daraus besteht.

4. Verfahren nach Anspruch 1 oder 2, **dadurch gekennzeichnet, dass** die wässerige Zusammensetzung oder/und die hieraus hergestellte organische Beschichtung ein Gemisch aus mindestens zwei verschiedene Gelbildner enthält.

5. Verfahren nach Anspruch 4, **dadurch gekennzeichnet, dass** die wässerige Zusammensetzung oder/und die hieraus hergestellte organische Beschichtung ein Gemisch aus zwei Pektinen enthält.

6. Verfahren nach einem oder mehreren der vorherigen Ansprüche, **dadurch gekennzeichnet, dass** die wässerige Zusammensetzung oder/und die hieraus hergestellte organische Beschichtung mindestens ein anionisches Polysaccharid ausgewählt aus solchen mit einem Veresterungsgrad der Carboxyfunktion im Bereich von 5 bis 75 % bezogen auf die Gesamtzahl der Alkohol- und Carboxygruppen enthält.

7. Verfahren nach einem oder mehreren der vorherigen Ansprüche, **dadurch gekennzeichnet, dass** die wässerige Zusammensetzung oder/und die hieraus hergestellte organische Beschichtung mindestens ein anionisches Polysaccharid oder/und mindestens einen anionischen Polyelektrolyten ausgewählt aus solchen mit einem Molekulargewicht im Bereich von 500 bis 1000000 g/mol⁻¹.

8. Verfahren nach einem oder mehreren der vorherigen Ansprüche, **dadurch gekennzeichnet, dass** die wässerige Zusammensetzung oder/und die hieraus hergestellte organische Beschichtung mindestens ein anionisches Polysaccharid oder/und mindestens einen anionischen Polyelektrolyten ausgewählt aus solchen mit einem Amidierungsgrad der Carboxyfunktionen im Bereich von 1 bis 50 % oder einem Epoxidierungsgrad der Carboxyfunktionen von bis zu 80 %.

9. Verfahren nach einem oder mehreren der vorherigen Ansprüche, **dadurch gekennzeichnet**, **dadurch gekennzeichnet, dass** die anionischen Polyelektrolyte modifiziert werden oder modifiziert sind mit Haftung vermittelnden Haftgruppen ausgewählt aus der Gruppe bestehend aus chemischen Gruppen von multifunktionalen Epoxiden, Isocyanaten, primären Aminen, sekundären Aminen, tertiären Aminen, quartären Aminen, Amiden, Imiden, Imidazolen, Formamiden, Michael-Reaktionsprodukten, Carbodiimiden, Carbenen, cyclischen Carbenen, Cyclocarbonaten, multifunktionalen Carbonsäuren, Aminosäuren, Nukleinsäuren, Methacrylamiden, Polyacrylsäuren, Polyacrylsäurederivaten, Polyvinylalkoholen, Polyphenolen, Polyolen mit mindestens einem Alkyl- und/oder Arylrest, Caprolactam, Phosphorsäuren, Phosphorsäureestern, Epoxidestern, Sulfonsäuren, Sulfonsäureestern, Vinylsulfonsäuren, Vinylphosphonsäuren, Katechol, Silanen sowie den hieraus gebildeten Silanolen und/oder Siloxanen, Triazinen, Thiazolen, Thiazinen, Dithiazinen, Acetalen, Halbacetalen, Chinonen, gesättigten Fettsäuren, ungesättigten Fettsäuren, Alkyden, Estern, Polyestern, Ethern, Glykolen, cyclischen Ethern, Kronenethern, Anhydriden, sowie von Acetylacetonen und von beta-Diketo-Gruppen, Carbonylgruppen und Hydroxy-Gruppen.

10. Verfahren nach einem oder mehreren der vorherigen Ansprüche, **dadurch gekennzeichnet, dass** die wässerige Zusammensetzung oder/und die hieraus hergestellte organische Beschichtung einen Gehalt an mindestens einem Komplexbildner für Metallkationen oder einem Polymer, welches Metallkationen komplexierend modifiziert ist, aufweist.

11. Verfahren nach Anspruch 10, **dadurch gekennzeichnet, dass** die wässerige Zusammensetzung oder/und die hieraus hergestellte organische Beschichtung einen Gehalt an mindestens einem Komplexbildner ausgewählt aus solchen auf Basis von Maleinsäure, Alendronsäure, Itaconsäure, Citraconsäure oder Mesaconsäure oder die Anhydride oder Halbester dieser Carbonsäuren aufweist.

12. Verfahren nach einem oder mehreren der vorherigen Ansprüche, **dadurch gekennzeichnet, dass** die wässerige Zusammensetzung oder/und die hieraus hergestellte organische Beschichtung mindestens eine Art von Kationen enthält, ausgewählt aus solchen auf Basis von kationisch wirkenden Salzen ausgewählt aus der Gruppe bestehend aus Melaminsalzen, Nitrososalzen, Oxoniumsalzen, Ammoniumsalzen, Salzen mit quaternären Stickstoffkationen, Salzen von Ammoniumderivaten und Metallsalzen von Ag, Al, Ba, Ca, Co, Cu, Fe, In, Mg, Mn, Mo, Ni, Pb, Sn, Ta, Ti, V, W, Zn oder/und Zr.

13. Verfahren nach Anspruch 12, **dadurch gekennzeichnet, dass** als Kationen, die aus der silikatischen Schicht herausgelöst oder/und die der wässerigen Zusammensetzung zur Einlagerung in die silikatische Schicht zugesetzt werden, Ag, Al, Cu, Fe, Mg oder/und Zn ausgewählt werden.

14. Verfahren nach einem oder mehreren der vorherigen Ansprüche, **dadurch gekennzeichnet, dass** die wässerige Zusammensetzung einen Vernetzer ausgewählt aus der Gruppe besteht aus: Silanen, Siloxanen, Phenolharztypen oder Aminen in einer Menge von 0,01 g/L bis 50 g/L enthält.

15. Verfahren nach einem oder mehreren der vorherigen Ansprüche, **dadurch gekennzeichnet, dass** die wässerige Zusammensetzung komplexe Titan- und /oder Zirkonfluoride in einer Menge von 0,01 g/L bis 50 g/L enthält.

16. Verfahren nach Anspruch 15, **dadurch gekennzeichnet, dass** die wässerige Zusammensetzung komplexe Titan- und /oder Zirkonfluoride in einer Menge von 0,1 g/L bis 30 g/L enthält.

17. Verfahren nach einem oder mehreren der vorherigen Ansprüche, **dadurch gekennzeichnet, dass** die wässerige Zusammensetzung einen Gehalt an mindestens einem Entschäumer aufweist.

18. Verfahren nach einem oder mehreren der vorherigen Ansprüche, **dadurch gekennzeichnet, dass** die wässerige Zusammensetzung mindestens ein Additiv ausgewählt aus der Gruppe bestehend aus: Pigmenten, Bioziden, Dispergierhilfsmitteln, Filmbildungshilfmitteln, saure oder/und basische Hilfsmittel zum Einstellen des pH-Werts und Verdicker und Verlaufsmittel enthält.

19. Verfahren nach einem oder mehreren der vorherigen Ansprüche, **dadurch gekennzeichnet, dass** vordem Kontaktieren und Beschichten der metallischen Oberflächen mit einer wässerigen Zusammensetzung in Verfahrensstufe II. die metallischen Oberflächen gereinigt, gebeizt oder/und vorbehandelt werden.

20. Verfahren nach einem oder mehreren der vorherigen Ansprüche, **dadurch gekennzeichnet, dass** die wässerige Zusammensetzung eine Beschichtung auf Basis eines ionogenen Gels ausbildet, und dass der dabei oder später ausgebildete Trockenfilm eine Dicke von mindestens 1 µm aufweist.

21. Verfahren nach einem oder mehreren der vorherigen Ansprüche, **dadurch gekennzeichnet, dass** die organische Beschichtung in 0,05 bis 20 Minuten im Tauchbad ausgebildet wird und nach dem Trocknen eine Trockenfilmdicke im Bereich von 5 bis 100 µm aufweist.

## Claims

1. A method for coating metallic surfaces of substrates, comprising or consisting of the following steps:
I. providing a substrate having a cleaned surface,
II. coating with an aqueous composition in the form of a dispersion and/or suspension of film-forming polymers which consists of a mixture of at least one stabilized polymer dispersion with a solids content of 30 to 80 wt% with a gel former in an amount of 0.001 to 20.0 wt%, based on the total mass of the resulting mixture, and with cations forms a coating based on an ionogenic gel;
III. optionally rinsing the organic coating and
IV. drying and/or baking the organic coating, or
V. optionally drying the organic coating and carrying out coating with a coating composition of the same kind or a further coating composition prior to drying and/or baking,
wherein
between step I and step II there is an additional coating operation with an aqueous composition in the form of a dispersion and/or suspension based on a colloidal silicatic sol that intercalates polyvalent metal cations, and optionally a washing step, wherein the polyvalent cations, when the aqueous composition is made up from demineralized water, are added before the following other constituents: 2.9 g/L Gardobond® Additive FI7107 and 22 g/L Gardobond® Oxsilan® Additive 9906 from Chemetall adjusted to about pH 4.5 with Gardobond® Oxsilan® Additive 9951 and 125 g/L Snowtex® O from Nissan Chemical.

2. The method according to claim 1, wherein the gel former comprises or consists of **a)** at least one polysaccharide based on glycogens, amyloses, amylopectins, calloses, agar, algins, alginates, pectins, carrageenans, celluloses, chitins, chitosans, curdlans, dextrans, fructans, collagens, gellan gum, gum arabic, starches, xanthans, tragacanth, karayans, tara gums, and glucomannans; **b)** at least one anionic polyelectrolyte of natural origin based on polyamino acids, collagens, polypeptides, lignins, and/or **c)** at least one synthetic anionic polyelectrolyte based on polyamino acids, polyacrylic acids, polyacrylic acid copolymers, acrylamide copolymers, lignins, polyvinylsulfonic acid, polycarboxylic acids, polyphosphoric acids or polystyrenes.

3. The method according to claim 1 or 2, wherein the gel former comprises or consists of at least one polysaccharide based on pectins or gellan gum.

4. The method according to claim 1 or 2, wherein the aqueous composition and/or the organic coating produced therefrom comprises a mixture of at least two different gel formers.

5. The method according to claim 4, wherein the aqueous composition and/or the organic coating produced therefrom comprises a mixture of two pectins.

6. The method according to one or more of the preceding claims, wherein the aqueous composition and/or the organic coating produced therefrom comprises at least one anionic polysaccharide selected from those having a degree of esterification of the carboxyl function in the range from 5% to 75% based on the total number of alcohol and carboxyl groups.

7. The method according to one or more of the preceding claims, wherein the aqueous composition and/or the organic coating produced therefrom at least one anionic polysaccharide and/or at least one anionic polyelectrolyte selected from those having a molecular weight in the range from 500 to 1 000 000 g/mol⁻¹.

8. The method according to one or more of the preceding claims, wherein the aqueous composition and/or the organic coating produced therefrom at least one anionic polysaccharide and/or at least one anionic polyelectrolyte selected from those having a degree of amidation of the carboxyl functions in the range from 1% to 50% or a degree of epoxidation of the carboxyl functions of up to 80%.

9. The method according to one or more of the preceding claims, wherein, wherein the anionic polyelectrolytes are modified or have been modified with adhesion-promoting tie groups selected from the group consisting of chemical groups of polyfunctional epoxides, isocyanates, primary amines, secondary amines, tertiary amines, quaternary amines, amides, imides, imidazoles, formamides, Michael reaction products, carbodiimides, carbenes, cyclic carbenes, cyclocarbonates, polyfunctional carboxylic acids, amino acids, nucleic acids, methacrylamides, polyacrylic acids, polyacrylic acid derivatives, polyvinyl alcohols, polyphenols, polyols having at least one alkyl and/or aryl radical, caprolactam, phosphoric acids, phosphoric esters, epoxide esters, sulfonic acids, sulfonic esters, vinylsulfonic acids, vinylphosphonic acids, catechol, silanes and also the silanols and/or siloxanes formed from them, triazines, thiazoles, thiazines, dithiazines, acetals, hemiacetals, quinones, saturated fatty acids, unsaturated fatty acids, alkyds, esters, polyesters, ethers, glycols, cyclic ethers, crown ethers, anhydrides, and also of acetylacetones and of beta-diketo groups, carbonyl groups, and hydroxyl groups.

10. The method according to one or more of the preceding claims, wherein the aqueous composition and/or the organic coating produced therefrom includes at least one complexing agent for metal cations, or a polymer which has been modified for complexation of metal cations.

11. The method according to claim 10, wherein the aqueous composition and/or the organic coating produced therefrom includes at least one complexing agent selected from those based on maleic acid, alendronic acid, itaconic acid, citraconic acid or mesaconic acid, or the anhydrides or monoesters of these carboxylic acids.

12. The method according to one or more of the preceding claims, wherein the aqueous composition and/or the organic coating produced therefrom comprises at least one kind of cations selected from those based on cationic salts selected from the group consisting of melamine salts, nitroso salts, oxonium salts, ammonium salts, salts with quaternary nitrogen cations, salts of ammonium derivatives, and metal salts of Ag, Al, Ba, Ca, Co, Cu, Fe, In, Mg, Mn, Mo, Ni, Pb, Sn, Ta, Ti, V, W, Zn and/or Zr.

13. The method according to claim 12, wherein cations selected that are extracted from the silicate layer and/or added to the aqueous composition for incorporation into the silicate layer are Ag, Al, Cu, Fe, Mg and/or Zn.

14. The method according to one or more of the preceding claims, wherein the aqueous composition contains a crosslinker selected from the group consisting of: silanes, siloxanes, phenolic resin types or amines in an amount of 0.01 g/L to 50 g/L.

15. The method according to one or more of the preceding claims, wherein the aqueous composition contains complex titanium and/or zirconium fluorides in an amount of 0.01 g/L to 50 g/L.

16. The method according to claim 15, wherein the aqueous composition contains complex titanium and/or zirconium fluorides in an amount of 0.1 g/L to 30 g/L.

17. The method according to one or more of the preceding claims, wherein the aqueous composition has a content of at least one defoamer.

18. The method according to one or more of the preceding claims, wherein the aqueous composition comprises at least one additive selected from the group consisting of: pigments, biocides, dispersing assistants, film-forming assistants, acidic and/or basic auxiliaries for adjusting the pH, and thickeners and flow control agents.

19. The method according to one or more of the preceding claims, wherein before the contacting and coating of the metallic surfaces with an aqueous composition in method stage II., the metallic surfaces are cleaned, pickled and/or pretreated.

20. The method according to one or more of the preceding claims, wherein the aqueous composition forms a coating based on an ionogenic gel, and wherein the dry film formed in this process or later has a thickness of at least 1 µm.

21. The method according to one or more of the preceding claims, wherein the organic coating forms in 0.05 to 20 minutes in the dipping bath and after drying has a dry film thickness in the range from 5 to 100 µm.

## Revendications

1. Procédé de revêtement de surfaces métalliques de substrats, comprenant les étapes suivantes ou constitué par les étapes suivantes :
I. la préparation d'un substrat comprenant une surface nettoyée,
II. le revêtement avec une composition aqueuse sous la forme d'une dispersion et/ou d'une suspension de polymères filmgènes, qui est constituée par un mélange d'au moins une dispersion de polymère stabilisée ayant une teneur en solides de 30 à 80% en poids avec un agent gélifiant en une quantité de 0,001 à 20,0% en poids, par rapport à la masse totale du mélange résultant, et forme avec des cations un revêtement à base d'un gel ionogène ;
III. éventuellement le rinçage du revêtement organique et
IV. le séchage et/ou la combustion du revêtement organique ou
V. éventuellement le séchage du revêtement organique et le revêtement avec une composition de revêtement de même type ou autre avant un séchage et/ou une combustion,
**caractérisé en ce que**
I et entre l'étape II, un revêtement additionnel avec une composition aqueuse sous la forme d'une dispersion et/ou d'une suspension à base d'un sol silicatique colloidal déposant des cations métalliques polyvalents et éventuellement une étape de rinçage ont lieu, les cations polyvalents étant ajoutés lors de la préparation de la composition aqueuse à partir d'eau entièrement desslée, avant l'ajout des autres constituants 2,9 g/l d'additif Gardobond® H7107 et 22 g/l d'additif Gardobond® Oxsilan® 9906 de la société Chemetall ajustés à pH 4,5 avec l'additif Gardobond® Oxsilan®9951 et 125 g/l de Snowtex®O de la société Nissan Chemical.

2. Procédé selon la revendication 1, **caractérisé en ce que** l'agent gélifiant contient **a)** au moins un polysaccharide à base de glycogènes, d'amyloses, d'amylopectines, de calloses, d'agar-agar, d'algines, d'alginates, de pectines, de carraghénanes, de celluloses, de chitines, de chitosans, de curdlanes, de dextranes, de fructanes, de collagènes, de gomme gellane, de gomme arabique, d'amidons, de xanthanes, de tragacanthe, de gomme karaya, de gomme tara et de glucomannanes ; **b)** au moins un polyélectrolyte anionique d'origine naturelle à base d'acides polyaminés, de collagènes, de polypeptides, de lignines et/ou **c)** au moins un polyélectrolyte anionique synthétique à base d'acides polyaminés, d'acides polyacryliques, de copolymères d'acides polyacryliques, de copolymères d'acrylamide, de lignines, d'acide polyvinylsulfonique, d'acides polycarboxyliques, d'acides polyphosphoriques ou de polystyrènes, ou en est constitué.

3. Procédé selon la revendication 1 ou 2, **caractérisé en ce que** l'agent gélifiant contient au moins un polysaccharide à base de pectines ou de gomme gellane ou en est constitué.

4. Procédé selon la revendication 1 ou 2, **caractérisé en ce que** la composition aqueuse et/ou le revêtement organique fabriqué à partir de celle-ci contiennent un mélange d'au moins deux agents gélifiants différents.

5. Procédé selon la revendication 4, **caractérisé en ce que** la composition aqueuse et/ou le revêtement organique fabriqué à partir de celle-ci contiennent un mélange de deux pectines.

6. Procédé selon une ou plusieurs des revendications précédentes, **caractérisé en ce que** la composition aqueuse et/ou le revêtement organique fabriqué à partir de celle-ci contiennent au moins un polysaccharide anionique choisi parmi ceux ayant un degré d'estérification de la fonction carboxy dans la plage allant de 5 à 75 % par rapport au nombre total de groupes alcool et carboxy.

7. Procédé selon une ou plusieurs des revendications précédentes, **caractérisé en ce que** la composition aqueuse et/ou le revêtement organique fabriqué à partir de celle-ci au moins un polysaccharide anionique et/ou au moins un polyélectrolyte anionique choisi parmi ceux ayant un poids moléculaire dans la plage allant de 500 à 1 000 000 g/mol⁻¹.

8. Procédé selon une ou plusieurs des revendications précédentes, **caractérisé en ce que** la composition aqueuse et/ou le revêtement organique fabriqué à partir de celle-ci au moins un polysaccharide anionique et/ou au moins un polyélectrolyte anionique choisi parmi ceux ayant un degré d'amidation des fonctions carboxy dans la plage allant de 1 à 50 % ou un degré d'époxydation des fonctions carboxy de jusqu'à 80 %.

9. Procédé selon une ou plusieurs des revendications précédentes, caractérisé en ce **caractérisé en ce que** les polyélectrolytes anioniques sont modifiés avec des groupes adhésifs conférant une adhésion choisis dans le groupe constitué par les groupes chimiques d'époxydes multifonctionnels, d'isocyanates, d'amines primaires, d'amines secondaires, d'amines tertiaires, d'amines quaternaires, d'amides, d'imides, d'imidazoles, de formamides, de produits de réaction de Michael, de carbodiimides, de carbènes, de carbènes cycliques, de cyclocarbonates, d'acides carboxyliques multifonctionnels, d'acides aminés, d'acides nucléiques, de méthacrylamides, d'acides polyacryliques, de dérivés d'acides polyacryliques, d'alcools polyvinyliques, de polyphénols, de polyols contenant au moins un radical alkyle et/ou aryle, de caprolactame, d'acides phosphoriques, d'esters d'acides phosphoriques, d'esters d'époxydes, d'acides sulfoniques, d'esters d'acides sulfoniques, d'acides vinylsulfoniques, d'acides vinylphosphoniques, de catéchol, de silanes, ainsi que des silanols et/ou siloxanes formés à partir de ceux-ci, de triazines, de thiazoles, de thiazines, de dithiazines, d'acétals, de semi-acétals, de quinones, d'acides gras saturés, d'acides gras insaturés, d'alkydes, d'esters, de polyesters, d'éthers, de glycols, d'éthers cycliques, d'éthers couronnes, d'anhydrides, ainsi que d'acétylacétones et de groupes bêta-dicéto, de groupes carbonyle et de groupes hydroxy.

10. Procédé selon une ou plusieurs des revendications précédentes, **caractérisé en ce que** la composition aqueuse et/ou le revêtement organique fabriqué à partir de celle-ci présentent une teneur en au moins un complexant pour cations métalliques ou un polymère qui est modifié pour la complexation de cations métalliques.

11. Procédé selon la revendication 10, **caractérisé en ce que** la composition aqueuse et/ou le revêtement organique fabriqué à partir de celle-ci présentent une teneur en au moins un complexant choisi parmi ceux à base d'acide maléique, d'acide alendronique, d'acide itaconique, d'acide citraconique ou d'acide mésaconique ou les anhydrides ou les semi-esters de ces acides carboxyliques.

12. Procédé selon une ou plusieurs des revendications précédentes, **caractérisé en ce que** la composition aqueuse et/ou le revêtement organique fabriqué à partir de celle-ci contiennent au moins un type de cations, choisis parmi ceux à base de sels à effet cationique choisis dans le groupe constitué par les sels de mélamine, les sels nitroso, les sels d'oxonium, les sels d'ammonium, les sels avec des cations d'azote quaternaire, les sels de dérivés d'ammonium et les sels métalliques d'Ag, Al, Ba, Ca, Co, Cu, Fe, In, Mg, Mn, Mo, Ni, Pb, Sn, Ta, Ti, V, W, Zn et/ou Zr.

13. Procédé selon la revendication 12, **caractérisé en ce qu'**Ag, Al, Cu, Fe, Mg et/ou Zn sont choisis en tant que cations qui sont extraits de la couche silicatique et/ou qui sont ajoutés à la composition aqueuse pour incorporation dans la couche silicatique.

14. Procédé selon une ou plusieurs des revendications précédentes, **caractérisé en ce que** la composition aqueuse contient un agent de réticulation choisi dans le groupe constitué par : les silanes, les siloxanes, les résines de type phénol ou les amines en une quantité de 0,01 g/l à 50 g/l.

15. Procédé selon une ou plusieurs des revendications précédentes, **caractérisé en ce que** la composition aqueuse contient des fluorures de titane et/ou de zirconium complexes en une quantité de 0,01 g/l à 50 g/l.

16. Procédé selon la revendication 15, **caractérisé en ce que** la composition aqueuse contient des fluorures de titane et/ou de zirconium complexes en une quantité de 0,1 g/l à 30 g/l.

17. Procédé selon une ou plusieurs des revendications précédentes, **caractérisé en ce que** la composition aqueuse présente une teneur en au moins un agent antimousse.

18. Procédé selon une ou plusieurs des revendications précédentes, **caractérisé en ce que** la composition aqueuse contien au moins un additif choisi dans le groupe constitué par : les pigments, les biocides, les adjuvants de dispersion, les adjuvants filmogènes, les adjuvants acides et/ou basiques pour l'ajustement du pH et les épaississants et les agents d'égalisation.

19. Procédé selon une ou plusieurs des revendications précédentes, **caractérisé en ce qu'**avant la mise en contact et le revêtement des surfaces métalliques avec une composition aqueuse à l'étape de procédé II., les surfaces métalliques sont nettoyées, décapées et/ou prétraitées.

20. Procédé selon une ou plusieurs des revendications précédentes, **caractérisé en ce que** la composition aqueuse forme un revêtement à base d'un gel ionogène et **en ce que** le film sec formé alors ou ultérieurement présente une épaisseur d'au moins 1 µm.

21. Procédé selon une ou plusieurs des revendications précédentes, **caractérisé en ce que** le revêtement organique est formé en 0,05 à 20 minutes dans le bain d'immersion et présente après le séchage une épaisseur de film sec dans la plage allant de 5 à 100 µm.
